# EUROPEAN PATENT APPLICATION

(11) **EP 1 453 095 A1**
(43) Date of publication of application: **01.09.2004**
(21) Application number: 02788611.8
(22) Date of filing: 12.11.2002
(51) Int. Cl.: H01L 27/11, H01L 21/8244

(54) **MEMORY DEVICE**

(30) Priority: 12.11.2001 JP 2001345551
(71) Applicant: NEC Corporation, Minato-ku, Tokyo 108-8001 (JP)
(72) Inventor: UEMURA, Tetsuya, Tokyo 108-8001 (JP)
(74) Representative: Patentanwälte Wenzel & Kalkoff
(86) International application number: PCT/JP2002/011804
(87) International publication number: WO 2003/043088

(57) **Abstract**

A memory device includes a plurality of memory cells, a first MOSFET, a resistance device and a second MOSFET. The plurality of memory cells is arranged in a matrix, and each of the plurality of memory cells is connected with a word line and a bit line and has memory capacitor. The first MOSFET is formed on a substrate, and a source region of the first MOSFET is connected with the bit line, a gate electrode thereof is connected with the word line and a drain region thereof is connected with the memory capacitor. The second MOSFET has a channel region electrically isolated from the substrate. The source region of the second MOSFET is connected with a first voltage through the resistance device and the source region is connected with the drain region of the first MOSFET. The gate electrode of the second MOSFET is connected with a second voltage and a drain region of the second MOSFET is connected with a third voltage.

## Description

### Technical Field

The present invention relates to a memory device and more particularly to arranging memory cells in a memory device having a differential negative resistance device.

### Background Art

A semiconductor random access memory (hereinafter, to be merely referred to as "RAM", too), especially, a dynamic RAM (DRAM) of the type of 1T/1C (1 transistor/1 capacitor) which is composed of one transistor and one capacitor element is known. Because the structure is simple, the DRAM of the type of 1T/1C is reaching the gate density of a giga bit level. However, charge as bit data accumulated in a capacitor element extinguishes at a predetermined time rate due to leak current. Therefore, in the DRAM of the type of 1T/1C, a refreshing operation needs to be carried out periodically at a rate of few times to a few thousand times per second.

On the other hand, a static RAM (SRAM) does not need the refreshing operation and can generally operate faster than the DRAM. However, the SRAM needs a flip-flop circuit and is generally composed of six transistors or of four transistors and two polysilicon load resistances. As a result, in case of the SRAM, the structure is complicated, compared with the DRAM, and the gate density is generally lower than the DRAM.

Therefore, a memory configuration is demanded which has a gate density as high as the DRAM and does not need the refreshing operation like SRAM.

As such memory structure, an SRAM cell using RTD (Resonant Tunneling Diode) and a tunnel diode is disclosed in Japanese Laid Open Patent Application (JP-A-Heisei 10-69766).

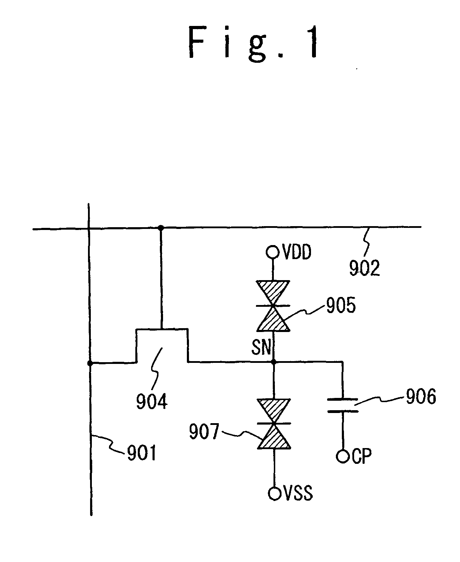

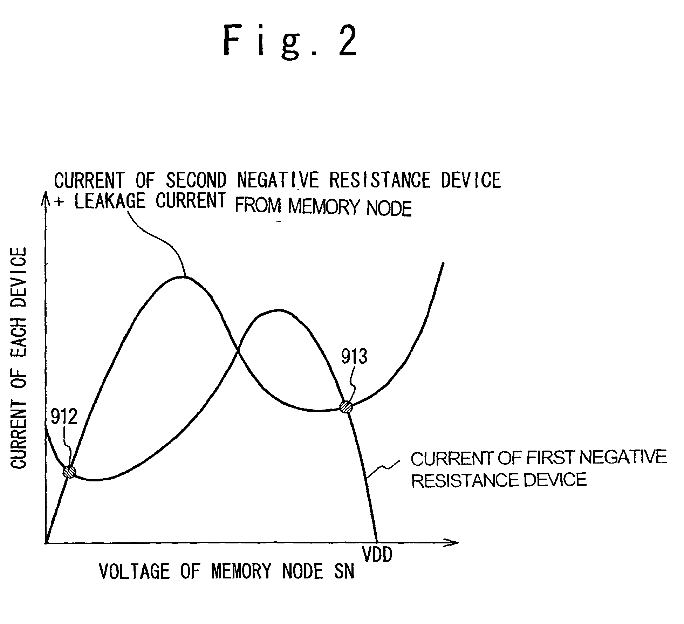

Fig. 1 is a diagram showing the circuit configuration of the memory cell in this conventional example. Fig. 2 is a diagram showing the operation of a latch circuit of the memory cell shown in Fig. 1. As shown in Fig. 1, the memory cell is composed of an n-channel FET 904, a cell capacitor 906 and negative resistance devices 905 and 907. The gate and drain of the n-channel FET 904 are connected with a word line 902 and a bit line 901, respectively. The cell capacitor 906 is connected between the source of the n-channel FET 904 and the cell plate CP. The negative resistance devices 905 and 907 are connected in series between power supply potentials VDD and VSS. A common node between the negative resistance devices 905 and 907 connected in series is connected with a memory node SN which is a node of the connection between the source of the n-channel FET 904 and the cell capacitor 906.

The memory cell holds data as electric charge accumulated in the cell capacitor 906, when the memory cell is in a stand-by state, i.e., the word line potential is low and the n-channel FET 904 is in an off state. In case of a usual DRAM, leak currents change the quantity of electric charge accumulated in the cell capacitor and the data cannot be held statically. On the other hand, as shown in Fig. 2, in a column circuit composed of the negative resistance devices 905 and 907, two stable operation points 912 and 913 exist. Therefore, the series circuit composed of the negative resistance devices 905 and 907 forms a latch circuit and the voltage of memory node SN is determined as either one of two voltages corresponding to the two stable operation points 912 and 913. In this way, it is possible to hold the data statically.

In the above-mentioned conventional memory cell, it is desirable that the current level of the negative resistance devices 905 and 907 is as low as possible from the viewpoint of consumption power. However, to secure the above-mentioned bi-stability, it is necessary that peak current values of the negative resistance devices 905 and 907 are larger at least than the leak current. The larger the peak current value is, the larger the operation margin becomes. To satisfy these conditions, it is desirable that the peak valley ratio (PV ratio), i.e., the ratio of a peak current value of the negative resistance devices 905 and 907 and the valley current value be as large as possible. However, a value of about 10 at most is only reported to the present time as the PV ratio of the negative resistance device which is used for the memory cell in the above-mentioned conventional example.

Also, the negative resistance device such as RTD and the tunnel diode is a bipolar device, and the fitness with the integrated circuit of the MOS structure which is generally used in the semiconductor memory device is poor.

A memory cell using a MOS transistor as the negative resistance device is disclosed in Japanese Laid Open Patent Application (JP-P2001-15757A). In the MOS transistor, it is possible to achieve the PV ratio of several digits and the fitness with the semiconductor memory device of the MOS structure is good.

By the way, in a semiconductor memory device, because many memory cells are arranged, the influence of the size of a single memory cell size upon the whole layout area of the semiconductor memory device is very large. Therefore, in the semiconductor memory device, it is very important to lay out memory cells of as small size as possible.

In the memory cell of a current DRAM, an arrangement system called a folded bit line system is used. Supposing that the minimum size (the design rule) is F, the minimum cell area is 8F² on theory. Therefore, in the memory device that the refreshing operation is made unnecessary by using a the negative resistance device, it is desirable that the memory cell area is as near 8F² as possible which is the theoretical minimum cell area of the current memory cell, and is suppressed to be equal to or less than 16F² even if maximum.

In conjunction with the above description, a static RAM is disclosed in Japanese Laid Open Patent Application (JP-A-Heisei 4-214289). In the static RAM of this conventional example, a resistance and a negative resistance device are connected in series between a power supply and the ground. One of the source and drain of the MOSFET is connected with a bit line and the other is connected with a node between the resistance and the negative resistance device. The gate of the MOSFET is connected with a word line.

Also, a semiconductor device is disclosed in Japanese Laid Open Patent Application (JP-A-Heisei 5-291533). In the semiconductor device of this conventional example, a first MOSFET having a gate, a source, and a drain is formed on a semiconductor substrate. The gate is connected with a power supply through a resistance. One of the source and drain electrodes of a second MOSFET is connected with a bit line and the other is connected with the gate of the first MOSFET. The gate of the second MOSFET is connected with a word line. A capacitor is connected between the gate electrode of the first MOSFET and the substrate to hold memory cell data.

Also, a semiconductor device is disclosed in Japanese Laid Open Patent Application (JP-P2001-15757). The semiconductor device of this conventional example has a channel region formed in a semiconductor substrate. A gate insulating film is formed on the channel region, and a gate electrode is formed on the gate insulating film. A source region and a drain region are formed to put the channel region between them. The drain region has a first region and a second region. The first region has a lower impurity density than the second region and the second region is connected to the ground. The first region is below the gate electrode and the second area is under the first area.

### Disclosure of Invention

Therefore, an object of the present invention is to provide a memory device, in which a refreshing operation is made unnecessary and a negative resistance device having a large PV ratio is used.

Also, another object of the present invention is to provide a memory device which has a memory cell with a same cell area as a memory cell of the current DRAM and in which a refreshing operation is made unnecessary.

Also, another object of the present invention is to provide a memory device in which a negative resistance device having a large PV ratio is used, a memory cell has a chip area near 8F² which is the minimum theoretical cell area of the memory cell of the current DRAM, and equal to or less than 16F² even if maximum, and refreshing operation is made unnecessary.

In the first aspect of the present invention, a memory device includes a memory first MOSFET, a resistance device and a second MOSFET. A plurality of memory cells is arranged like a matrix, each of which is connected with a word line and a bit line and has a memory capacitor. The first MOSFET is formed on a substrate, the source region is connected with the bit line, the gate electrode is connected with the word line and the drain region is connected with the memory capacitor. The second MOSFET has a channel region which is electrically isolated from the substrate. The source region of the second MOSFET is connected with a first voltage through the resistance device and is also connected with the drain region of the first MOSFET. The gate electrode of the second MOSFET is connected with the second voltage and the drain region is connected with the third voltage.

Here, the second MOSFET has a negative resistance characteristic.

Also, the memory device may include a trench formed in the substrate and an insulating film connected with the trench and formed in the substrate to electrically isolate the channel region of the second MOSFET from the substrate. The second MOSFET may be formed in the region surrounded by the trench and the insulating film.

Also, the memory device may further include an interlayer insulating film formed to cover the first MOSFET on the substrate, and the second MOSFET may be formed on the interlayer insulating film. In this case, it is desirable that the source region of the first MOSFET is common to the source region of another first MOSFET and the drain region of the second MOSFET is common to the drain region of another second MOSFET.

Also, the memory device may further include a trench formed in the substrate, and the drain region of the second MOSFET may be connected with the trench and may be formed in the substrate to electrically isolate the channel region of the second MOSFET from the substrate.

Also, the memory device may further include the trench formed in the substrate. It is desirable that the source region, channel region and drain region of the second MOSFET are formed to be connected with the trench in order from the surface of the substrate, and the gate electrode of the second MOSFET is formed to be connected with the sides of the source region and the channel region through the gate oxide film and to be connected with the surface of the drain region.

Here, the substrate and the drain region of the second MOSFET is a same conductive type, and the drain region of the second MOSFET may be connected with the third voltage through the substrate. Besides, the substrate and the drain region of the second MOSFET may be a different conductive type.

Also, the memory device may include a drain impurity region formed on a substrate as the drain of the first MOSFET and the drain region of the second MOSFET, and the channel region and the source region of the first MOSFET may be formed on the drain impurity area in order, the gate electrode of the first MOSFET is connected with the sides of the source region and the channel region through a gate oxide film, and to be connected with the surface of the drain impurity region. The channel region and the source region of the second MOSFET may be formed on the drain impurity region in order, and the gate electrode of the second MOSFET may be formed to be connected with the sides of the source region and the channel region through a gate oxide film and to be connected with the surface of the drain impurity region.

The resistance device may be a resistor. Also, the resistance device may be a diode that is biased in a reverse direction. The resistance device may be a transistor which operates in a saturation region.

When the resistance device is a third MOSFET which operates in a saturation region, the channel region and the source region of the third MOSFET may be formed on the drain impurity region in order, the gate electrode of the third MOSFET may be formed to be connected with the sides of the source region and the channel region through a gate oxide film and to be connected with the surface of the drain impurity region. In this case, it is desirable that the gate electrode of the second MOSFET is common to the gate electrode of the third MOSFET.

A first direction of the source region, the channel region and the drain region in the first MOSFET is parallel to a second direction of the source region, the channel region and the drain region in the second MOSFET, and a third direction of the drain region of the first MOSFET and the source region of the second MOSFET may be orthogonal to the first direction.

Also, the plurality of memory cells may be connected with the bit lines in a folded bit type.

The first voltage and the second voltage may be the same voltage and the second voltage and the third voltage may be the same voltage.

In the second aspect of the present invention, the memory device includes a plurality of memory cells arranged like a matrix, each of which is connected with a word line and a bit line and has a capacitor element, a first MOSFET that the source region is connected with the bit line, the gate electrode is connected with the word line and the drain region is connected with the capacitor element, and a bi-stable circuit connected with the drain of the first MOSFET and having a negative resistance characteristic.

It is desirable that the current value of the bi-stable circuit is smaller than the current value of the first MOSFET.

Also, it is desirable that the bi-stable circuit is composed of a load and a negative resistance device having the negative resistance characteristic.

The peak valley current ratio in the negative resistance characteristic is equal to or more than 10.

The resistance device may be a resistor. Also, the resistance device may be a diode that is biased in a reverse direction. The resistance device may be a transistor which operates in a saturation region.

### Brief Description of Drawings

Fig. 1 is a diagram showing a circuit structure of a conventional memory cell;
Fig. 2 is a diagram showing an operation of a latch circuit in the memory cell shown in Fig. 1;
Fig. 3 is a cross sectional view showing the structure of a memory cell of a memory device according to a first embodiment of the present invention;
Fig. 4A is a plan view showing the memory cell of the memory device according to the first embodiment of the present invention, and Fig. 4B is a diagram showing a layout of the memory device;
Fig. 5A is a diagram showing a voltage - current characteristic between a source and a drain in a field effect transistor used for the memory cell of the memory device according to the first embodiment of the present invention, and Fig. 5B is a diagram showing an operation of a latch circuit;
Fig. 6 is a cross sectional view showing two memory cells of the memory device according to a second embodiment of the present invention;
Fig. 7 is a diagram showing the layout of a memory cell of the memory device according to the second embodiment of the present invention;
Fig. 8 is a cross sectional view showing the memory cell of the memory device according to a third embodiment of the present invention;
Fig. 9A is a plan view showing the memory cell of the memory device according to the third embodiment of the present invention, and Fig. 9B is a diagram showing a layout of the memory cell in the third embodiment;
Fig. 10 is a cross sectional view showing the structure of the memory cell of the memory device according to a fourth embodiment of the present invention;
Fig. 11A is a diagram showing a voltage - current characteristic between a source and a drain in the field effect transistor used for the memory cell of the memory device according to the fourth embodiment of the present invention, and Fig. 11B is a diagram showing an operation of the latch circuit;
Fig. 12 is a cross sectional view showing the structure of the memory cell of the memory device according to a fifth embodiment of the present invention;
Fig. 13 is a cross sectional view showing the structure of the memory cell of the memory device according to a sixth embodiment of the present invention;
Fig. 14A is a plan view showing the memory cell of the memory device according to the sixth embodiment of the present invention, and Fig. 14B is a diagram showing a layout of the memory cell in the sixth embodiment; and
Fig. 15A is a diagram showing a voltage - current characteristic between a source and a drain in the field effect transistor used for the memory cell of the memory device according to the sixth embodiment of the present invention, and Fig. 15B is a diagram showing an operation of the latch circuit.

### Best Mode for Carrying Out the Invention

Hereinafter, a memory device of the present invention will be described in detail, with reference to the attached drawings.

### [First Embodiment]

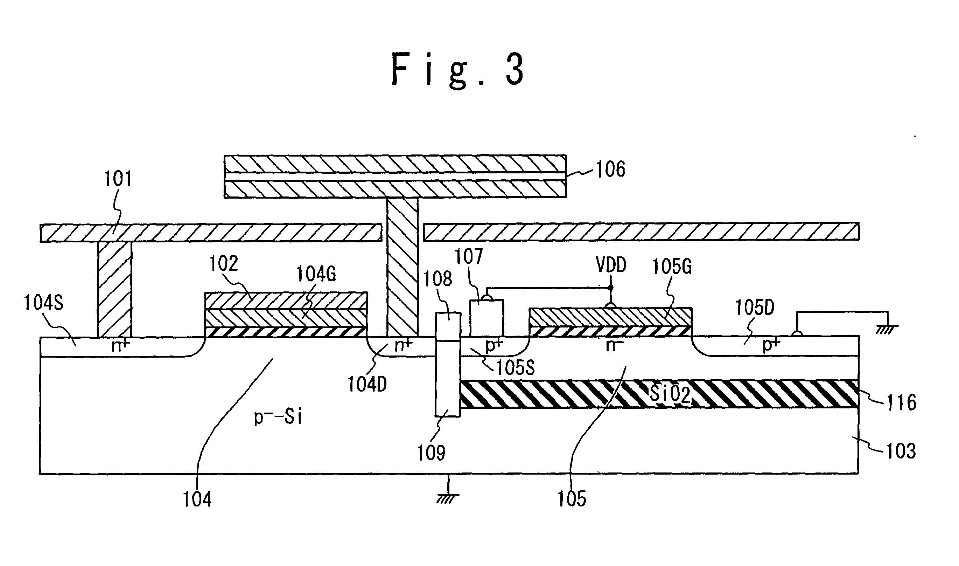

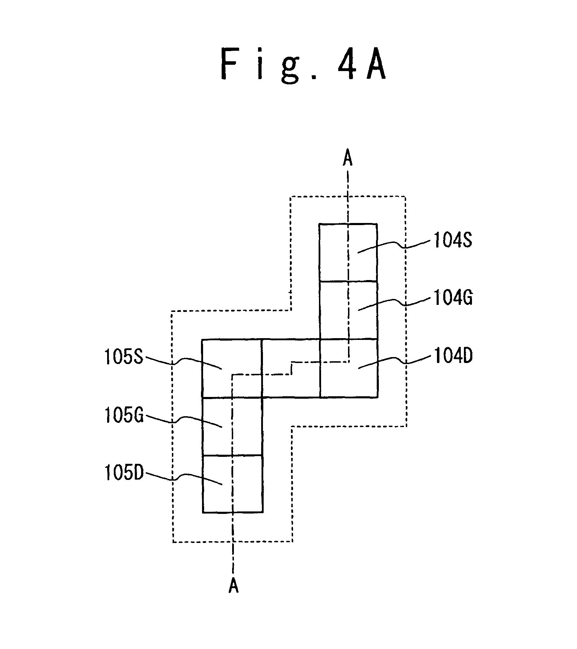

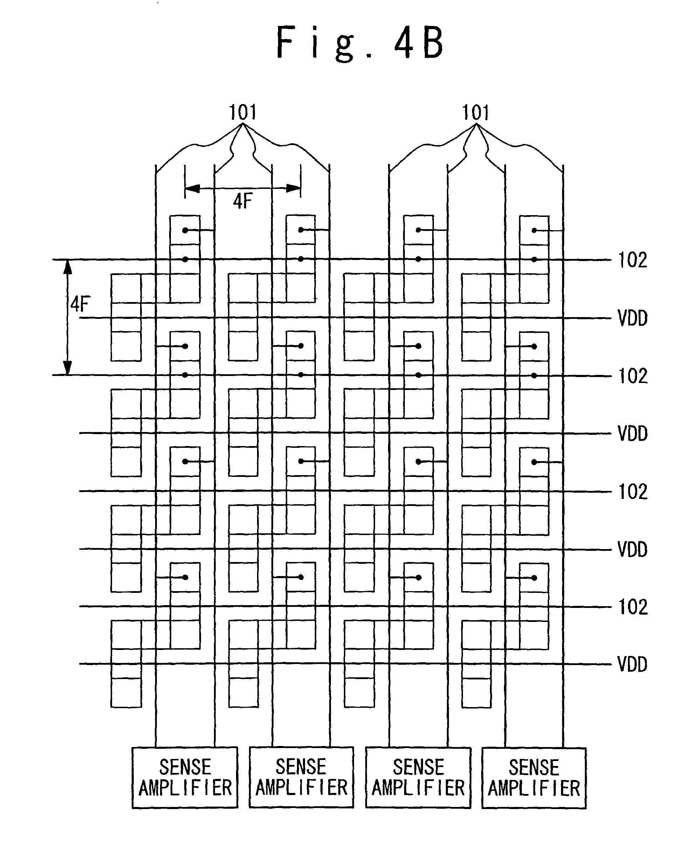

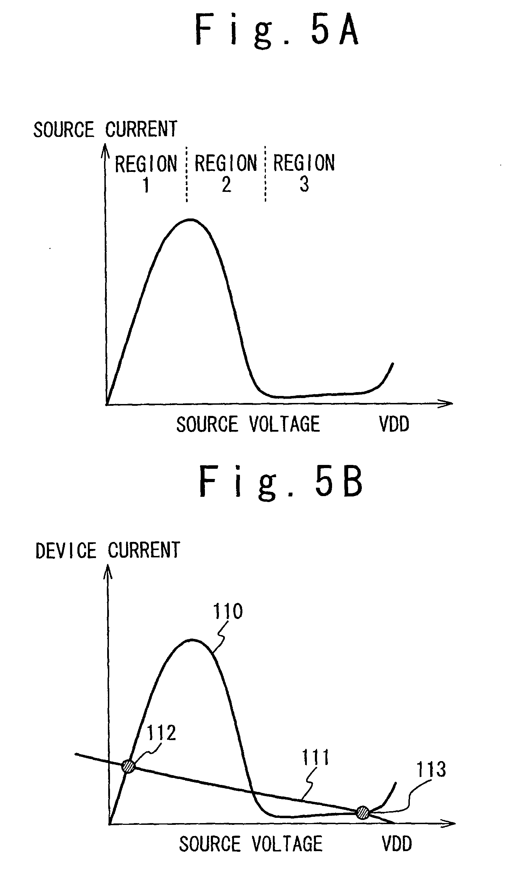

Fig. 3 is a cross sectional view showing the structure of the memory cell of the memory device according to the first embodiment of the present invention. Fig. 4A is a plan view showing the memory cell of Fig. 3, and Fig. 4B is a diagram showing a layout of the memory cells shown in Fig. 3. Fig. 5A is a graph showing a voltage - current characteristic between a source and a drain in a field effect transistor used for the memory cell shown in Fig. 3, and Fig. 5B is a diagram showing an operation of a latch circuit of the memory cell shown in Fig. 3.

As shown in Fig. 3, the memory cell of the memory device in the first embodiment is composed of a field effect transistor 104, a field effect transistor 105, a cell capacitor 106 and a resistance device 107. The field effect transistor 104 is formed on a substrate 103. The field effect transistor 105 is provided on a position adjacent to the field effect transistor 104, and a channel region of the field effect transistor 105 has a structure electrically isolated from the substrate 103. The resistance device 107 is provided on a source region 105S of the field effect transistor 105 and is connected with the source region 105S at its one end. A gate electrode 104G of the field effect transistor 104 is connected with a word line 102, the source region 104S thereof is connected with a bit line 101 and the drain region 104D thereof is connected with the cell capacitor 106 and the source region 105S of the field effect transistor 105. The other end resistance device 107 and the gate electrode 105G of the field effect transistor 105 are both fixed to a first potential and the drain region 105D of the field effect transistor 105 are fixed on a second potential.

Fig. 4A is a plan view showing the memory cell shown in Fig. 3. Fig. 3 is the cross sectional view of the memory cell along the A-A line of Fig. 4A. A direction in which the source region 104S, gate electrode 104G and drain region 104D of the field effect transistor 104 are arranged and a direction in which the source region 105S, gate electrode 105G and drain region 105D of the field effect transistor 105 are parallel. Also, the direction in which the drain region 104D of the field effect transistor 104 and the source region 105S of the field effect transistor 105 are arranged is orthogonal to the above directions. The field effect transistor 104 and the field effect transistor 105 are formed in such an arrangement relation. The resistance device 107 is provided on the source region 105S of the field effect transistor 105 to be connected with it.

Operation of the memory cell in case that the field effect transistor 104 is an n-channel MOSFET, the field effect transistor 105 is a p-channel MOSFET, the first voltage is a power supply voltage VDD, and the second voltage is the ground voltage (0V) will be described. An insulating layer 116 like a SiO₂ layer and a trench 109 are formed between the channel section of the field effect transistor 105 and the substrate 103, and the channel section of the field effect transistor 105 and the substrate 103 are electrically isolated.

Fig. 5A is a graph showing a voltage -current characteristic between a source and a drain in the field effect transistor 105 when the power supply voltage VDD is applied to the gate electrode 105G of the field effect transistor 105. In this state, a device structure of the field effect transistor 105 such as the thickness of a gate insulating film and an impurity dope quantity is appropriately designed such that in the neighbor of a channel surface, electric field intensity at the end of the drain contacting the channel region is a strength (approximately 1 MV/cm or more) which makes it possible for carriers such as electrons and holes to carry out interband tunneling, when the positive voltage VDD is applied to the gate electrode 105G. Fig. 5A is a graph showing the characteristic when the power supply voltage VDD is 3.3 V and the film thickness of the gate insulating film is 5 nm.

Because the electric field sufficient for the interband tunneling to be carried out is formed at the end of the drain, electrons in the valence band in the drain region easily tunnels to a conduction band in the channel region when the positive voltage is applied to the source region. The electrons having tunneled into the conduction band in the channel region ride over an energy barrier between the source region and the channel region and flow outside to form tunnel current [Region 1 of Fig. 5A].

When the voltage applied to the source region further increases, the electric field intensity at the end of the drain becomes weak. Therefore, tunnel probability decreases and the current between the source and the drain decreases [Region 2 Fig. 5A]. If the electric field intensity at the end of the gate is weaker than an electric field intensity that the interband tunneling can be maintained, the current between the source and the drain gets not to flow perfectly.

Moreover, when the voltage applied to the source region further more increases, diffusion current flows through the PN junction which is formed by the source region and the channel region [Region 3 of Fig. 5A].

In the above description, the stronger the electric field intensity generated by the gate voltage in the channel surface becomes, the larger the tunnel current becomes. Therefore, it is effective to increase the tunnel current that the power supply voltage VDD is high or the gate insulating film is thin. Also, it is possible to increase the peak valley current ratio of the negative resistance device to a value of two digits or more by appropriately setting device parameters such as a dope quantity of impurity and a gate length in the drain region.

It is supposed that one end of the resistance device 107 is connected with the source region 105S of the field effect transistor 105 having a negative resistance characteristic, the gate electrode 105G is connected with the other end of the resistance device 107, and the power supply voltage VDD and the ground potential are respectively applied to the gate electrode 105G and the drain region 105D. Also, it is supposed that voltage applied to the source region 105S of the field effect transistor 105 is increased from 0 V to the power supply voltage VDD. In this case, as shown in Fig. 5B, it is possible to set the operation of the resistance device 107 and the field effect transistor 105 by adjusting the resistance value of the resistance device 107, such that the current curve 111 of the resistance device 107 and the current curve 110 between the source and the drain in the field effect transistor 105 intersect at three points. Here, a leak current component IL from the memory node 108 is contained in the current curve 111 of the resistance device 107. Two points 112 and 113 in which the current curve 111 of the resistance device 107 and the current curve 110 between the source and the drain in the field effect transistor 105 intersect are stable operation points. Therefore, a latch circuit can be formed to have the two points 112 and 113 as the stable operation points, by connecting the source of the field effect transistor 105 and the resistance device 107.

When the memory cell is in the stand-by state, the memory node 108 connected with the source region 105S of the field effect transistor 105 is held in a voltage of either of the two stable points 112 and 113 by this latch circuit. Thus, the memory device in the first embodiment can operate as an SRAM.

It is desirable from the viewpoint of power consumption that the hold current level of the latch circuit is as low as possible. However, in order to secure a bi-stable operation, it is necessary that the peak current value of the negative resistance characteristic of the field effect transistor 105 is set to be at least larger than the leak current component IL of the memory cell. Considering change in the leak current value between the memory cells, it is desirable for the peak current value to be set to about 50 to 100 times of the average leak current value (about 1 to 10 fA). As described above, it is possible to increase the peak valley current ratio of the field effect transistor 105 as the negative resistance device to a value of two digits or more at this time. Therefore, the valley current can be set to a small value equal to the leak current value, for example. Thus, the stand-by power consumption can be made small, compared with the memory cell using the conventional negative resistance device that the peak valley current (PV) ratio is about 10. Also, for comparison with the conventional DRAM in which a refreshing operation is carried out, it is supposed that the power supply voltage VDD is 3.3 V, a bit line capacitor and a cell capacitor are 270 fF and 27 fF, respectively, an average leak current level of the memory cell is 1 fA and the peak current value and the peak valley current ratio of the field effect transistor are 100 fA and 100, respectively. In this case, the power consumption of the memory cell of this embodiment in the stand-by state is small by about three digits, compared with the conventional DRAM which has the same power supply voltage VDD, the same bit line capacitor, the same cell capacitor and the same cell leak current level and the refreshing operation is carried out for every 128 milliseconds.

Fig. 4B is a diagram showing a memory cell array in which the memory cells shown in Fig. 4A are arranged in a matrix manner of 4 x 4. In each of the memory cells, the source region, the gate region and the drain region in each of the field effect transistors 104 and the field effect transistors 105 are arranged along the bit line 101. The gate electrode 104G of the field effect transistor 104 is connected with the word line 102 and the source region 104S is connected with the bit line 101. Also, the gate electrode 105G of the field effect transistor 105 is connected with the power supply potential VDD. One pair of parallel bit lines is connected with the same sense amplifier to form a folded type of bit lines. Since one period of the arrangement of the memory cells in the row or column direction is 4F, the chip area occupied by each memory cell in this arrangement is 4F x 4F (= 16F²).

The read/write operation to the memory cell is completely the same as the conventional 1T/1C type DRAM. That is, in the read operation, the voltage of the selected word line 102 is boosted to the power supply voltage VDD in the state that the bit line 101 is precharged and the field effect transistor 104 is turned on. At this time, a potential change occurs in the bit line 101 due to the electric charge accumulated by the cell capacitor 106 and this potential change is amplified by a sense amplifier. Data on the bit line 101 which is amplified by the sense amplifier is read out from the memory cell array as the "H" state or the "L" state in accordance with a quantity of electric charge accumulated by the cell capacitor 106. At the same time, the rewrite of the data is carried out and the electric charge is returned into the memory cell through the field effect transistor 104. Also, in the write operation, like the read operation, the voltage of the selected word line 102 is boosted to the power supply voltage VDD in the state that write data is held and the field effect transistor 104 is turned on. The voltage of the bit line relating to the memory cell to which the write operation is carried out is compulsorily changed in accordance with the input data and the data is written in the memory cell.

When the potential of the word line 102 changes to VDD during the read operation and the write operation, a latch circuit operates to raise the potential of the memory node 108 to VDD, because the voltage of the latch circuit composed of the field effect transistor 105 and the resistance device 107 is VDD. However, as mentioned above, because the current level of the latch circuit is sufficiently smaller than the drive current of the field effect transistor 104 and the sense amplifier, the time constant when the potential of the memory node 108 is raised to VDD becomes longer than the access time of the memory cell. For example, when the peak current level of the latch circuit is 100 fA and the bit line capacitor is 270 fF, the time constant when the potential of the memory node 108 is raised to VDD is equal to or more than 3 seconds. This is long sufficiently compared with an average access time of 80 nanoseconds in the memory cell, and the influence of the latch circuit on the access operation of the memory cell in this situation can be ignored.

As described above, in the memory device of the first embodiment, the current level of the field effect transistor 105 is set as small as possible in the range in which the bi-stability of the latch circuit is not damaged. As a result, in the memory device of the first embodiment, the influence of the latch circuit to the read operation and write operation can be ignored. Therefore, the memory cell can achieve (1) the access time equal to a usual DRAM, and (2) the stand-by power consumption lower than the DRAM.

Also, because the field effect transistor 105 has a high peak valley current ratio, the extension of operation margin and the low consumption power operation can be achieved, compared with the conventional memory device.

Moreover, the memory device in the first embodiment realizes the above-mentioned effects while maintaining the chip area of 16F² occupied by each memory cell which is equal to the current DRAM.

It should be noted that the potential applied to the gate electrode 105G of the field effect transistor 105 and the potential applied to the terminal of the resistance device 107 on the side opposite to the memory node 108 may not always be the same.

### [Second Embodiment]

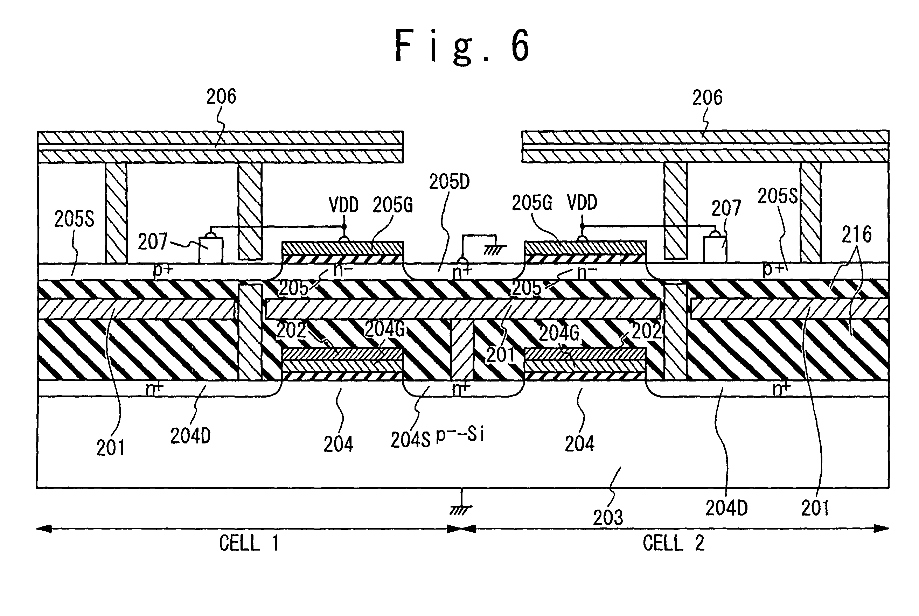

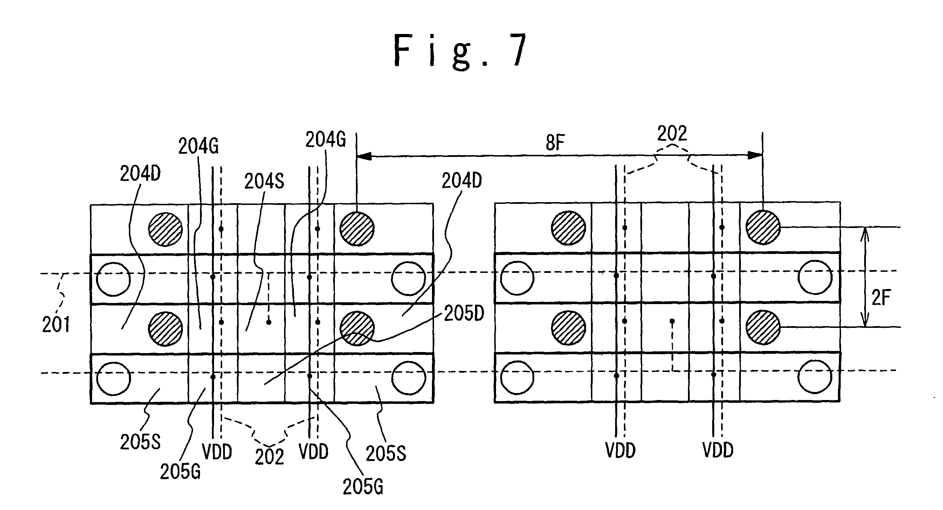

Fig. 6 is a cross sectional view showing the memory device according to the second embodiment of the present invention for two memory cells. Fig. 7 is a layout diagram showing the memory cells shown in Fig. 6.

As shown in Fig. 6, each of the memory cell 1 and the memory cell 2 as memory cells of the memory device in the second embodiment is composed of a field effect transistor 204, a field effect transistor 205, a cell capacitor 206 and a resistance device 207. The field effect transistor 204 is formed on a substrate 203. The field effect transistor 205 is formed through an insulating layer 216 on the field effect transistor 204. The resistance device 207 is formed on the source region 205S of the field effect transistor 205 to contact the source region 205S at one end. The gate electrode 204G of the field effect transistor 204 is connected with the word line 202, the source region 204S thereof is connected with the bit line 201 and the drain region 204D thereof is connected with the source region 205S of the field effect transistor 205 and the cell capacitor 206. The other end of the resistance device 207 and the gate electrode 205G of the field effect transistor 205 are both fixed to a first voltage and the drain electrode 205D of the field effect transistor 205 is fixed to a second voltage.

Fig. 7 shows a memory cell array in which the memory cells shown in Fig. 6 are arranged in a row direction and a column direction for 8 x 8. The area surrounded by the thick line shows an area for the field effect transistor 205 of the laminate structure shown in Fig. 6. A painted circle and a non-painted circuit show a connection portion of the drain region 204D of the field effect transistor 204 and the cell capacitor 206 and a connection portion of the source region 205S of the field effect transistor 205 and the cell capacitor 206, respectively. The source region 204S of the field effect transistor 204 and the drain region 205D of the field effect transistor 205 are shared by the memory cell 1 and the memory cell 2. The direction in which the source region 204S, gate electrode 204G and drain region 204D of the field effect transistor 204 are arranged andthe direction in which the source region 205S, gate electrode 205G and drain region 205D of the field effect transistor 205 extend are parallel over all the memory cells. Also, the direction in which the drain region 204D of the field effect transistor 204 and the source region 205S of the field effect transistor 205 are arranged is orthogonal to the above directions. In this way, the field effect transistor 204 and the field effect transistor 205 are formed. The resistance device 207 is provided on the source region 205S of the field effect transistor 205 adjacent to a portion where the source region 205S is connected with the cell capacitor 206.

The source region, gate electrode and drain region of each of the field effect transistor 204 and the field effect transistor 205 are arranged along a bit line 201. The gate electrode 204G of the field effect transistor 204 is connected with a word line 202 and the source region 204S is connected with the bit line 201. Also, the gate electrode 205G of the field effect transistor 205 is connected with a power supply voltage VDD. Because one period of the arrangement in the row and column directions for the two memory cells is 2F and 8F, respectively, the cell area of each memory cell is (8F×2F)/2 = 8F² in case of this arrangement.

In the memory device of the second embodiment, it is supposed that the field effect transistor 204 is an n-channel MOSFET, the field effect transistor 205 is a p-channel MOSFET, the first voltage is the power supply voltage VDD and the second voltage is the ground voltage (0V). In this case, the connection between the circuit elements is the same as in the first embodiment, and the operation becomes the same as in the first embodiment. Moreover, in the memory device of the second embodiment, the latch circuit composed of the field effect transistor 205 and the resistance device 207 is formed above the field effect transistor 204. Therefore, the cell area becomes small compared with the case of the first embodiment, and the cell area of 8F² equal to a usual DRAM can be realized.

### [Third Embodiment]

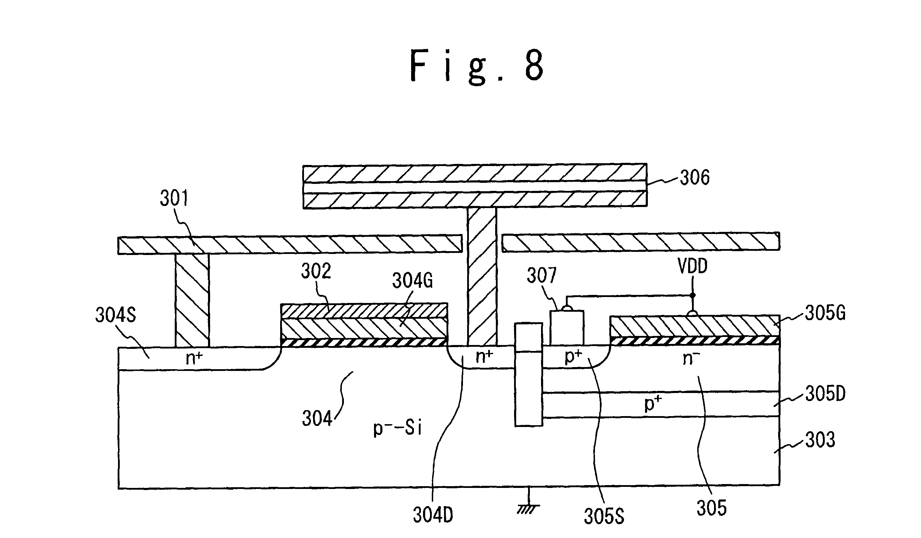

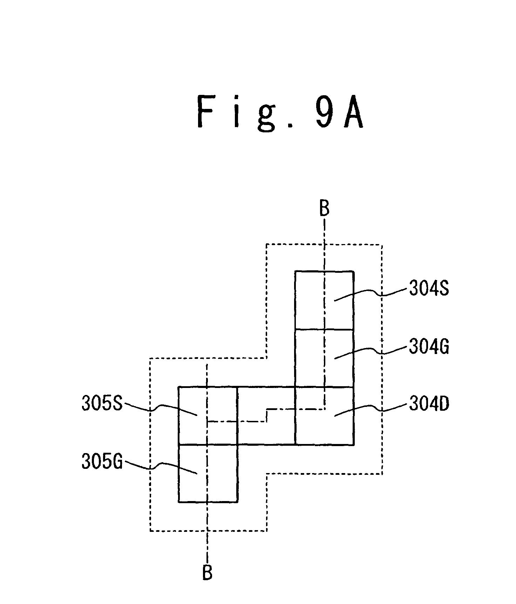

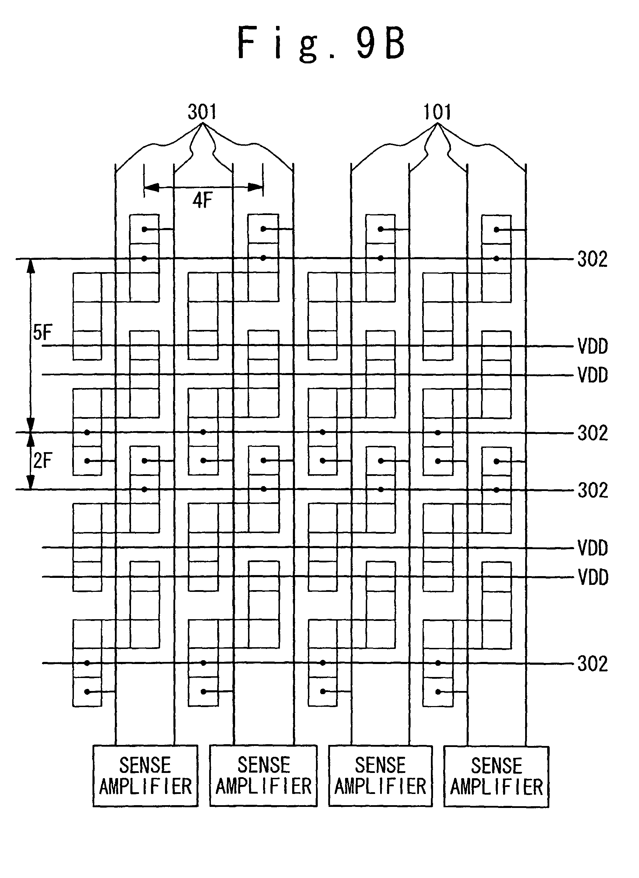

Fig. 8 is a cross sectional view showing the memory cell of the memory device according to the third embodiment of the present invention. Fig. 9A is a plan view showing the memory cell shown in Fig. 8, and Fig. 9B is a layout diagram showing the memory device shown in Fig. 8. Fig. 8 is the cross sectional view showing the memory device along the line B-B in Fig. 9A.

As shown in Fig. 8, the memory cell of the memory device in the third embodiment is composed of a field effect transistor 304, a field effect transistor 305, a cell capacitor 306 and a resistance device 307, like the first embodiment. The field effect transistor 304 is formed on a substrate 303. The field effect transistor 305 is provided adjacent to the field effect transistor 304, and a channel region is electrically isolated from the substrate 303. The resistance device 307 is formed on a source region 305S of the field effect transistor 305 to be connected with the source region 305S at one end. A gate electrode 304G of the field effect transistor 304 is connected with a word line 302, a source region 304S thereof is connected with a bit line 301 and a drain region 304D thereof is connected with the source region 305S of the field effect transistor 305 and the cell capacitor 306. The other end of the resistance device 307 and the gate electrode 305G of the field effect transistor 305 are both fixed to a first voltage. The third embodiment is different from the first embodiment in the point that the drain region 305D of the field effect transistor 305 is formed between the channel region and the substrate 303, and the drain region 305D of the field effect transistor 305 is fixed to a second voltage through the substrate 303.

Fig. 9A is a plan view showing the memory cell shown in Fig. 8.The direction in which the source region 304S, gate electrode 304G and drain region 304D of the field effect transistor 304 are arranged is parallel to the direction in which the source region 305S and gate electrode 305G of the field effect transistor are arranged. Also, the direction in which the drain region 304D of the field effect transistor 304 and the source region 305S of the field effect transistor 305 are arranged is orthogonal to the above directions. In this way, the field effect transistor 304 and the field effect transistor 305 are formed. The resistance device 307 is connected on the source region 305S of the field effect transistor.

Fig. 9B shows a memory cell array that the memory cells shown in Fig. 9A are arranged in row and column direction for 4 x 4. The source region 304S, gate electrode 304G and drain region 304D of the field effect transistor 304, and the source region 305S and gate electrode 305G of the field effect transistor 305 are arranged along a bit line 301 over all the memory cells. The gate electrode 304G of the field effect transistor 304 is connected with a word line 302, and the source region 304S is connected with the bit line 301. Also, the gate electrode 305G of the field effect transistor 305 is connected with the power supply voltage VDD. One pair of the bit lines is arranged in parallel to a same sense amplifier and forms a folded type of bit lines. One period of the arrangement in the column and row directions for the two memory cells are 4F and (5F+2F), the cell area of each memory cell is (4F×7F)/2 = 14F² in case of this arrangement.

It is supposed that the field effect transistor 304 is an n-channel MOSFET, the field effect transistor 305 is a p-channel MOSFET, the first voltage is the power supply voltage VDD, and the second voltage is the ground voltage (0V). In this case, the drain region 305D of the second transistor 305 and the substrate 303 are of a p type. Therefore, a part of the substrate 303 can be set as the drain region 305D of the field effect transistor 305. At this time, when the substrate 303 is connected with the ground voltage (0V), the drain region 305D of the field effect transistor 305 is connected with the ground voltage (0V). The third embodiment is different from the first embodiment in that the channel region of the field effect transistor 305 is electrically isolated from the substrate 303 without forming an insulating layer between the field effect transistor 305 and the substrate 303. Therefore, a negative resistance appears in the current voltage characteristic between the source and the drain of the field effect transistor 305.

As described above, the connection between the circuit elements is the same as in the first embodiment, and the memory device in the third embodiment shows the same circuit operation as that of the first embodiment. The memory device in the third embodiment can be realized in the cell area of 14F² in those circuit operations.

### [Fourth Embodiment]

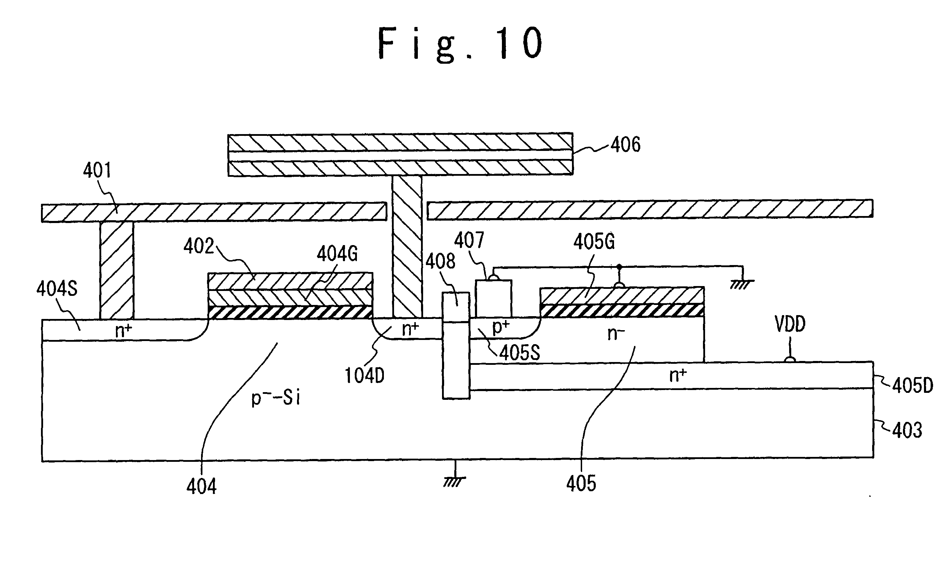

Fig. 10 is a cross sectional view showing the memory cells of the memory device according to the fourth embodiment of the present invention. As shown in Fig. 10, the memory cell of the memory device in the fourth embodiment is composed of a field effect transistor 404, a field effect transistor 405, a cell capacitor 406 and a resistance device 407. The field effect transistor 404 is formed on a substrate 403. The field effect transistor 405 is provided adjacent to the field effect transistor 404, and a channel region is electrically isolated from the substrate 403. The resistance device 407 is formed on a source region 405S of the field effect transistor 405 to be connected with the source region 405S at one end. The gate electrode 404G of the field effect transistor 404 is connected with a word line 402, the source region 404S thereof is connected with a bit line 401 and the drain region 404D thereof is connected with the source region 405S of the field effect transistor 405 and the cell capacitor 406. The other end of the resistance device 407 and the gate electrode 405G of the field effect transistor 405 are both fixed to a first voltage and the drain region 405D of the field effect transistor 405 is fixed to a second voltage. The memory cell in the fourth embodiment is different from the first embodiment in the point that the drain region 405D of the field effect transistor 405 is formed between the channel region and the substrate 403.

A plan view and a layout diagram of the memory cell of the memory device in the fourth embodiment are the same as the first embodiment shown in Figs. 4A and 4B and the cell area is 16F².

It is supposed that the field effect transistor 404 and the field effect transistor 405 are n-channel MOSFETs, the first voltage is the ground voltage (0V) and the second voltage is the power supply voltage VDD. In this case, a reverse bias voltage is applied to the PN junction which is formed between the drain region 405D of the field effect transistor 405 and the substrate 403 to electrically isolate them. Therefore, in the memory cell of the fourth embodiment, the channel region of the field effect transistor 405 is isolated from the substrate 403.

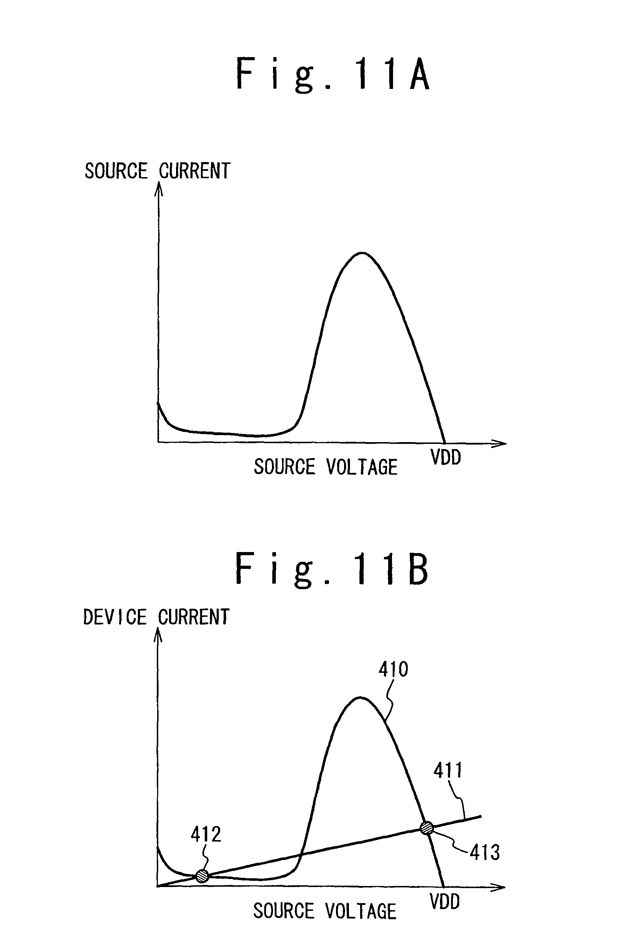

As shown in Fig. 11A, in the field effect transistor 405, the current voltage characteristic between the source and the drain shows a negative resistance characteristic in the state that the drain voltage and the gate voltage are fixed to the power supply voltage of VDD and 0 V, respectively, by adequately designing a device structure such as a gate insulating film thickness and an impurity dope quantity, as in the first embodiment. A voltage applied to the source region 405S of the field effect transistor 405 is swept from 0 V to the power supply voltage VDD in the state that the resistance device 407 with a suitable resistance value is inserted between the source region 405S and the gate electrode 405G of the field effect transistor 405, and the drain voltage and the gate voltage of the field effect transistor 405 are fixed to the power supply voltage of VDD and 0 V, respectively. At this time, the current curve 411 of the resistance device 407 and the current curve 410 of the field effect transistor 405 intersect at three points, as shown in Fig. 11B. Here, leak current IL from a memory node 408 is contained in the current curve 411 of the resistance device 407. Therefore, by inserting the resistance device 407 with a suitable resistance value between the source region 405S and the gate electrode 405G of the field effect transistor 405, a latch circuit can be formed to have two stable operation points 412 and 413. The memory device in the fourth embodiment operates like the above-mentioned embodiments.

### [Fifth Embodiment]

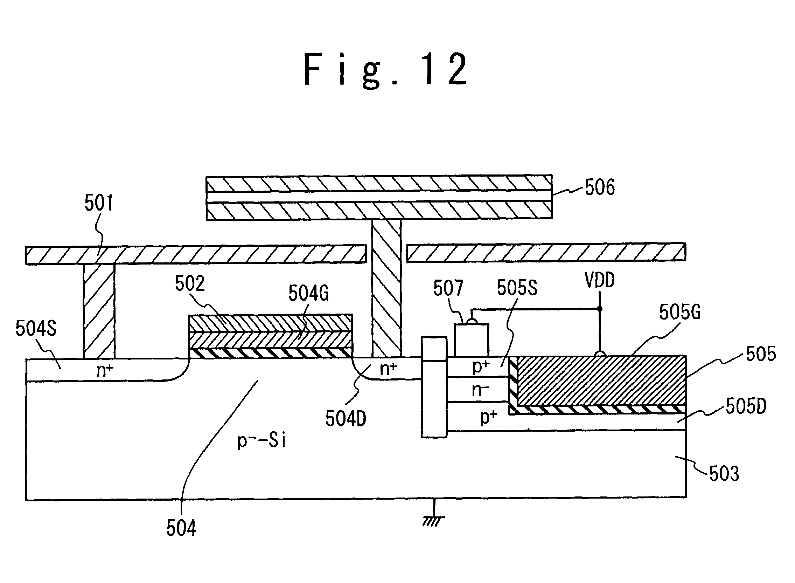

Fig. 12 is a cross sectional view showing the memory cell of the memory device according to the fifth embodiment of the present invention. As shown in Fig. 12, the memory cell of the memory device in the fifth embodiment is composed of a field effect transistor 504, a field effect transistor 505, a cell capacitor 506 and a resistance device 507, like the third embodiment. The field effect transistor 504 is formed on a substrate 503. The field effect transistor 505 is adjacent to the field effect transistor 504 and has a structure that the channel region is electrically isolated from the substrate 503. The resistance device 507 is formed on the source region 505S of the field effect transistor 505 to connect with the source region 505S at one end. The gate electrode 504G of the field effect transistor 504 is connected with a word line 502, the source region 504S thereof is connected with a bit line 501 and the drain region 504D thereof is connected with the source region 505S of the field effect transistor 505 and the cell capacitor 506. The other ends of the resistance device 507 and the gate electrode 505G of the field effect transistor 505 are both fixed to a first voltage. The drain region 505D of the field effect transistor 505 is formed between the channel region and the substrate 503, and the drain region 505D of the field effect transistor 505 is fixed to a second voltage through the substrate 503. The fifth embodiment is different from the third embodiment in the point that the gate electrode 505G of the field effect transistor 505 is provided being in contact with the side wall of the channel.

The plan view of the memory cell and layout of the memory cells in the memory device of the fifth embodiment are the same as those of the third embodiment shown by Figs. 9A and 9B, respectively, and the cell area is 14F².

The memory device of the fifth embodiment shows the same circuit operation as the memory devices of the above-mentioned embodiments.

### [Sixth Embodiment]

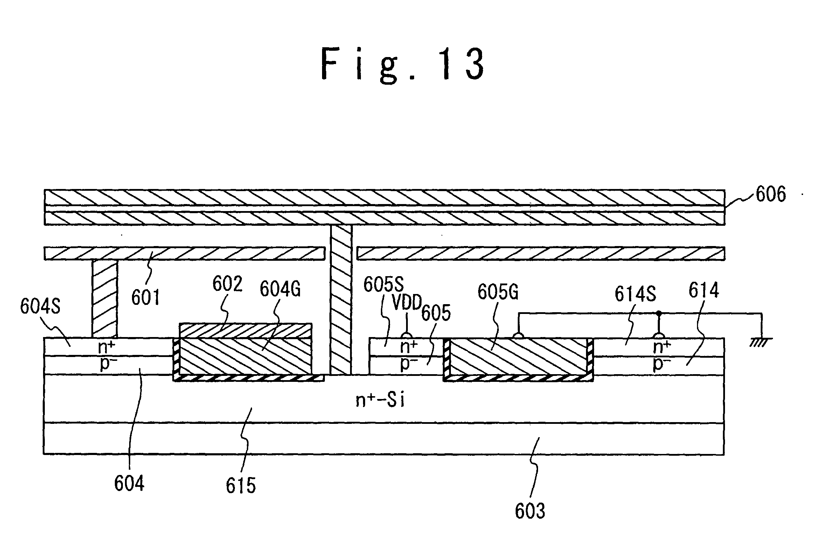

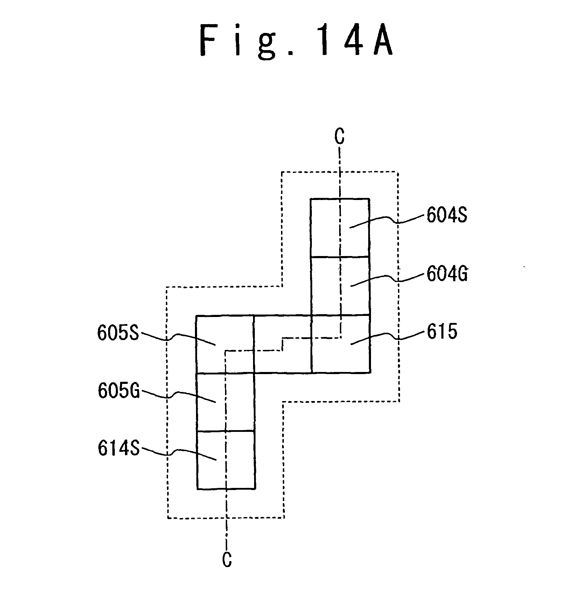

Fig. 13 is a cross sectional view showing the memory cell of the memory device according to the sixth embodiment of the present invention. Fig. 14A show a plan view showing the memory cell shown in Fig. 13. Fig. 13 is the cross section view of the memory device along the C-C line shown in Fig. 14A.

As shown in Fig. 13, the memory cell of the memory device in the sixth embodiment is composed of a substrate 603, three vertical-type field effect transistors of a field effect transistor 604, a field effect transistor 605 and a field effect transistor 614 and a cell capacitor 606. In three vertical-type field effect transistors, a drain, a channel, and a source region are stacked above the substrate 603 in order and the gate is formed in contact with a side wall of the channel. The drain regions of the field effect transistor 604, field effect transistor 605 and field effect transistor 614 are connected to each other and formed to have a common drain region 615 on the substrate. One end of the cell capacitor 606 is connected with the common drain region 615, the gate electrode 604G of the field effect transistor 604 is connected with a word line 602 and the source region 604S thereof is connected with a bit line 601. The gate electrode 605G of the field effect transistor 605 which is common to the gate electrode of the field effect transistor 614, and the source region 614S of the field effect transistor 614 are both fixed to a first voltage. The source region 605S of the field effect transistor 605 is fixed to a second voltage. In this way, the common drain region 615 to the field effect transistor 604, the field effect transistor 605 and the field effect transistor 614 is connected with the one end of the cell capacitor 606. Also, all the three field effect transistors adopt the vertical-type structure and are compactly formed.

The direction in which the source region 604S, gate electrode 604G and common drain region 615 of the field effect transistor 604 are arranged is parallel to the direction in which the source region 605S and gate electrode 605G of the field effect transistor 605 are arranged, as shown in Fig. 14A. Also, the direction in which the common drain region 615 and the source region 605S of the field effect transistor 605 are arranged is orthogonal to the above directions. In this way, the field effect transistor 604 and the field effect transistor 605 are formed. The field effect transistor 614 is formed adjacent to the gate electrode 605G of the field effect transistor 605.

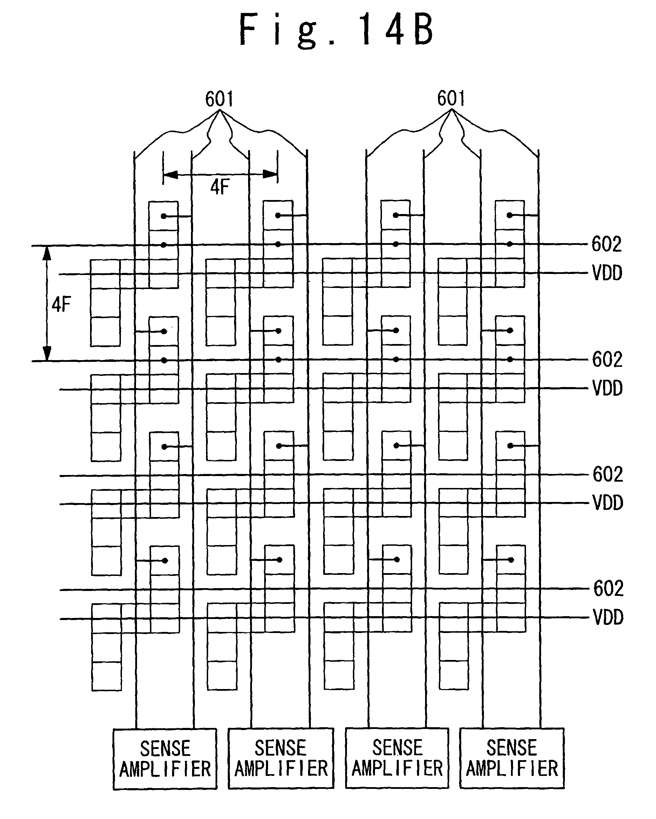

Fig. 14B shows a memory cell array in which the memory cells of Fig. 14A are arranged in the row and column directions for 4 bits x 4 bits. The source region 604S, gate electrode 604G, and drain region 604D of the field effect transistor 604, and the source region 605S and gate electrode 605G of the field effect transistor 605 are arranged along a bit line 601, over all the memory cells. The gate electrode 604G of the field effect transistor 604 is connected with a word line 602, and the source region 604S thereof is connected with the bit line 601. Also, the gate electrode 605G of the field effect transistor 605 is connected with a first voltage. One pair of the bit lines arranged in parallel toward the same sense amplifier forms a folded type of bit lines. The cell area of each memory cell in case of this arrangement is 16F², like the first embodiment.

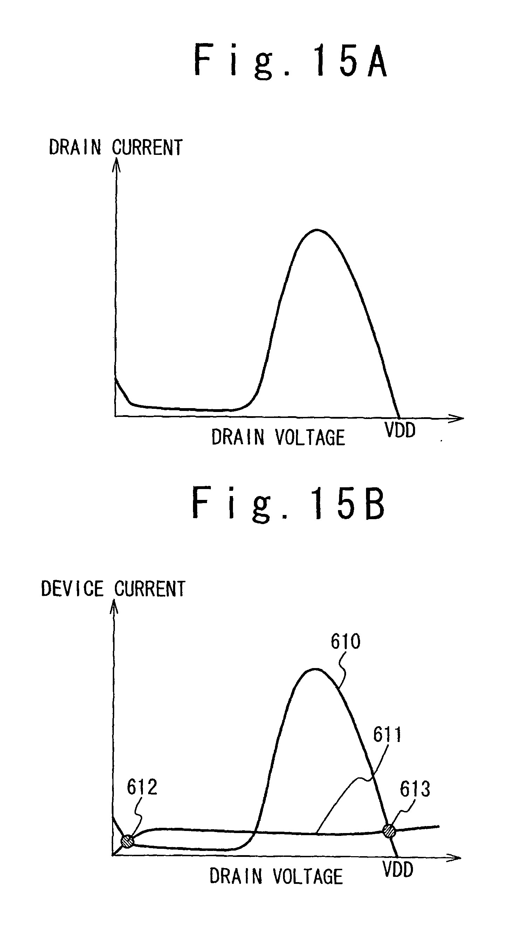

It is supposed that the field effect transistor 604, the field effect transistor 605 and the field effect transistor 614 are n-channel MOSFETs, the first voltage is the ground voltage and the second voltage is the power supply voltage VDD. Also, as shown in Fig. 15A, the field effect transistor 605 shows a negative resistance characteristic to the current - voltage characteristic between the source and the drain in the state that a source voltage and a gate voltage are fixed to the power supply voltages of VDD and 0 V, respectively. On the other hand, in the field effect transistor 614, source voltage and gate voltage are fixed to 0 V, and the current - voltage characteristic between the source and the drain shows a saturation characteristic.

Fig. 14B shows the current 610 which flows between the source and the drain in the field effect transistor 605 and the current 611 which flows between the source and the drain in the field effect transistor 614, when the voltage of the common drain 615 is swept from 0 V to the power supply voltage VDD, in the circuit composed of the field effect transistor 605 and the field effect transistor 614 shown in Fig. 13. The gate electrode 605G and the source region 614S in the field effect transistor 614 are both connected with the ground voltage, and therefore, a reverse direction saturation current only flows between the source and the drain. The circuit composed of the field effect transistor 605 and the field effect transistor 614 shown in Fig. 13 forms a latch circuit having two stable operation points 612 and 613.

The memory device of the sixth embodiment also shows a circuit operation like the above-mentioned embodiments.

Moreover, in the memory device of the sixth embodiment, no resistance device and field effect transistor are inserted between the drain region 605D and the gate electrode 605G in the field effect transistor 605. Therefore, a hold current level can be reduced due to a saturation characteristic.

In the first and second embodiments of the present invention, the case has been described that the field effect transistors 104 and 204 are the n-channel MOSFETs, the field effect transistors 105 and 205 are the p-channel MOSFETs, the first voltage is the power supply voltage VDD, and the second voltage is the ground voltage (0V). However, otherwise, it is possible to use the n-channel MOSFETs as the field effect transistors 104 and 204, the p-channel MOSFET as the field effect transistors 105 and 205, the ground voltage as the first potential, and the power supply voltage VDD as the second potential. Also, it is possible to use the n-channel MOSFETs as the field effect transistors 104 and 204 and the field effect transistors 105 and 205, the ground voltage as the first voltage, and the power supply voltage VDD as the second voltage. Moreover, it is possible to use the p-channel MOSFETs as the field effect transistors 104 and 204 and the field effect transistors 105 and 205, the power supply voltage VDD as the first voltage, and the ground voltage as the second voltage.

In the third and fifth embodiments of the present invention, a case has been described that the n-channel MOSFETs are used as field effect transistors 304 and 504, the p-channel MOSFETs are used as field effect transistors 305 and 505, the power supply voltage VDD is used as the first voltage and the ground voltage (0V) is used as the second voltage. However, otherwise, it is possible to use the p-channel MOSFETs as the field effect transistors 304 and 504, the n-channel MOSFETs as the field effect transistors 305 and 505, the ground voltage (0V) as the first voltage and the power supply voltage VDD as the second voltage. In this case, the substrate is of n-type and the conductive type of the drain regions of the field effect transistors 305 and 505 and that of the substrate are same, a part of the substrate can be used as the drain region of the field effect transistor. Also, because the power supply voltage VDD is applied to the drain regions of the field effect transistors 305 and 505 when the power supply voltage VDD is applied by the substrate, the same operation as the above-mentioned memory cell can be achieved.

In the memory cell of the fourth embodiment of the present invention, a case has been described that the n-channel MOSFETs are used as the field effect transistors 404 and 405, the ground voltage (0V) is used as the first voltage and the power supply voltage VDD is used as the second voltage. However, otherwise, it is possible to use the p-channel MOSFETs as the field effect transistors 404 and 405, the power supply voltage VDD as the first potential and the ground voltage (0V) as the second voltage.

As the resistance device in the first to fifth embodiments, it is possible to use a diode. Herein, the diode is connected for a voltage to be applied in a reverse direction.

In the sixth embodiment of the present invention, a case has been described that the n-channel MOSFETs are used as the field effect transistors 604 to 614, the ground voltage (0V) is used as the first voltage and the power supply voltage VDD is used as the second voltage. However, otherwise, it is possible to use the p-channel MOSFETs as the field effect transistors 604 to 614, the power supply voltage VDD as the first voltage and the ground voltage (0V) as the second voltage.

The present invention has been described based on the preferable embodiments as described above. However, the memory device of the present invention is not limited only to the above-mentioned embodiments. Memory devices to which various modifications are applied within a range that is not outside the scope of the present invention, are also contained in the scope of the present invention. For example, the substrate is not limited to Si substrate and an optimal semiconductor substrate may be used. Also, the cell capacitor is formed above the semiconductor substrate. However, the cell capacitor may be formed in the semiconductor substrate to have a trench structure.

As described above, in the memory device of the present invention, the resistance device and the negative resistance device having the field effect transistor structure and indicative of a high peak valley current ratio are connected between the two reference voltage and memory node of the memory cell having the DRAM of the usual 1T/1C structure. In this way, a wide operation margin and a low power consumption operation can be realized, compared with the conventional memory device which can hold data statically, and the memory device can be realized in the cell area of 16F² to 8F² equal to the current DRAM.

## Claims

1. A memory device comprising:
a plurality of memory cells arranged in a matrix, wherein each of said plurality of memory cells is connected with a word line and a bit line and has memory capacitor;
a first MOSFET formed on a substrate, wherein a source region of said first MOSFET is connected with said bit line, a gate electrode thereof is connected with said word line and a drain region thereof is connected with said memory capacitor;
a resistance device;
a second MOSFET which has a channel region and which is electrically isolated from said substrate, wherein a source region of said second MOSFET is connected with a first potential through said resistance device and said source region is connected with said drain region of said first MOSFET, a gate electrode of said second MOSFET is connected with a second potential and a drain region of said second MOSFET is connected with a third potential.

2. The memory device according to claim 1,
wherein said second MOSFET is a memory device having a negative resistance characteristic.

3. The memory device according to claim 1 or 2, further comprising:
a trench formed in said substrate; and
an insulating film which is connected with said trench and is formed on said substrate to electrically isolate said channel region of said second MOSFET from said substrate,
wherein said second MOSFET is formed in an area surrounded by said trench and said insulating film.

4. The memory device according to claim 1 or 2, further comprising:
an interlayer insulating film formed on said substrate to cover said first MOSFET,
wherein said second MOSFET is formed on said interlayer insulating film.

5. The memory device according to claim 4, wherein said source region of said first MOSFET is common to a source region of another first MOSFET, and
said drain region of said second MOSFET is common to a drain region of another second MOSFET.

6. The memory device according to claim 1 or 2, further comprising:
a trench formed in said substrate,
wherein said drain region of said second MOSFET is connected with said trench and formed in said substrate to electrically insulate said channel region of said second MOSFET from said substrate.

7. The memory device according to claim 1 or 2, further comprising:
a trench formed in said substrate,
wherein said source region, said channel region and said drain region of said second MOSFET are formed in order from a surface of said substrate to be connected with said trench, and
said gate electrode of said second MOSFET is formed to be connected with a side of said source region and a side of said channel region through the gate oxide film and to be connected with a surface of said drain region.

8. The memory device according to claim 6 or 7, wherein said substrate and said drain region of said second MOSFET is a same conductive type, and
said drain region of said second MOSFET is connected with said third potential through said substrate.

9. The memory device according to claim 6 or 7, wherein a conductive type of said substrate is different from a conductive type of said drain region of said second MOSFET.

10. The memory device according to claim 1 or 2, wherein a drain impurity region is formed on said substrate as said drain region of said first MOSFET and said drain region of said second MOSFET,
said channel region and said source region of said first MOSFET are formed in order on said drain impurity region, said gate electrode of said first MOSFET is formed to be connected with a side of said source region and a side of said channel region through said gate oxide film and to be connected with a surface in said drain impurity region, and
said channel region and said source region of said second MOSFET are formed in order on said drain impurity region, said gate electrode of said second MOSFET is formed to be connected with a side of said source region and a side of said channel region through said gate oxide film and to be connected with a surface of said drain impurity region.

11. The memory device according to any of claims 1 to 10, wherein said resistance device is a resistor.

12. The memory device according to any of claims 1 to 10, wherein said resistance device is a diode which is biased in a reverse direction.

13. The memory device according to any of claims 1 to 9, wherein said resistance device is a transistor which operates in a saturation region.

14. The memory device according to claim 10, wherein said resistance device is a third MOSFET which operates in a saturation region,
a channel region and a source region of said third MOSFET are formed in order on said drain impurity region, and
a gate electrode of said third MOSFET is formed to be connected with a side of said source region and a side of said channel region through a gate oxide film and to be connected with a surface in said drain impurity region.

15. The memory device according to claim 10, wherein said gate electrode of said second MOSFET is common to said gate electrode of said third MOSFET.

16. The memory device according to any of claims 1 to 15, wherein a first direction of said source region, said channel region and said drain region of said first MOSFET is parallel to a second direction of said source region, said channel region and said drain region of said second MOSFET,
a third direction of said drain region of said first MOSFET and said source region of said second MOSFET is orthogonal to said first direction.

17. The memory device according to any of claims 1 to 15, wherein said plurality of memory cells is connected with bit lines in a folded bit system.

18. The memory device according to any of claims 1 to 9, wherein said first potential and said second potential are a same potential.

19. The memory device according to claim 9, wherein said second potential and said third potential are a same potential.

20. A memory device comprising:
a plurality of memory cell arranged in a matrix, wherein each of said plurality of memory cells is connected with a word line and a bit line and has a capacitor device;
said first MOSFET having a source region connected with said bit line, a gate electrode connected with said word line, and a drain region connected with said capacitor device; and
a bi-stable circuit connected with said drain of said first MOSFET and having a negative resistance characteristic.

21. The memory device according to claim 20, wherein a current value of said bi-stable circuit is smaller than a current value of said first MOSFET.

22. The memory device according to claim 20, wherein said bi-stable circuit comprises:
a load;
a negative resistance device having said negative resistance characteristic.

23. The memory device according to claim 22, wherein a peak valley current ratio of said negative resistance characteristic is equal to or more than 10.

24. The memory device according to claim 23, wherein said load is a resistor.

25. The memory device according to claim 22 or 23, wherein said load is a diode that is biased in a reverse direction.

26. The memory device according to claim 22 or 23, wherein said load is a transistor which carries out a saturation operation.
